(19) **Europäisches Patentamt**
**European Patent Office**
**Office européen des brevets**

(11) **EP 4 181 319 B1**

(12) **EUROPEAN PATENT SPECIFICATION**

(45) Date of publication and mention
of the grant of the patent:
**13.09.2023 Bulletin 2023/37**

(21) Application number: **21216486.7**

(22) Date of filing: **21.12.2021**

(51) International Patent Classification (IPC):
$H01Q\ 3/26^{(2006.01)}$     $H01Q\ 3/28^{(2006.01)}$
$H01Q\ 3/38^{(2006.01)}$     $H01Q\ 3/36^{(2006.01)}$
$H01Q\ 21/06^{(2006.01)}$

(52) Cooperative Patent Classification (CPC):
**H01Q 21/061; H01Q 3/267; H01Q 3/28; H01Q 3/36**

(54) **ANTENNA ARRAY CALIBRATION DEVICE AND METHOD THEREOF**

ANTENNEN-ARRAY-KALIBRIERVORRICHTUNG UND VERFAHREN DAFÜR

DISPOSITIF D'ÉTALONNAGE DE RÉSEAU D'ANTENNES ET PROCÉDÉ ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.11.2021 TW 110141779**

(43) Date of publication of application:
**17.05.2023 Bulletin 2023/20**

(73) Proprietor: **Industrial Technology Research
Institute
Chutung, Hsinchu 310401 (TW)**

(72) Inventors:
• **Hwang, Ruey-Bing
Hsinchu City (TW)**
• **Tsai, Yueh-Lin
Yunlin County (TW)**

(74) Representative: **dompatent von Kreisler Selting
Werner -
Partnerschaft von Patent- und Rechtsanwälten
mbB
Deichmannhaus am Dom
Bahnhofsvorplatz 1
50667 Köln (DE)**

(56) References cited:
• **ZHANG LU ET AL: "Amplitude and phase
correction of the phased array antenna by REV
algorithm", 2017 2ND INTERNATIONAL
CONFERENCE ON IMAGE, VISION AND
COMPUTING (ICIVC), IEEE, 2 June 2017
(2017-06-02), pages 913-917, XP033124939, DOI:
10.1109/ICIVC.2017.7984687 [retrieved on
2017-07-18]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**CROSS-REFERENCE TO RELATED APPLICATIONS**

**BACKGROUND**

1. Technical Field

The present invention relates to the field of antenna array calibration device and method thereof, and more particularly, to an antenna array calibration device and method thereof capable of using both phase rotation and amplitude attenuation to achieve fast calibration.

2. Related Art

In modern days, phased array antennas are indispensable technologies in mobile communications, satellite communications systems, and military radar systems. To achieve accurate beam forming, the vector electric field (which includes both the amplitude and phase) of each radiating element of the array antenna must be accurately controlled. However, due to the amplitude and phase of each radio frequency (RF) path cannot in perfect consistency, the initial amplitudes and initial phases of the phase shifters being equivalent to random variables, the existence of the electromagnetic couple between antennas, etc., the amplitude and phase of each radiating antenna present in a random manner. Therefore, how to utilize the electromagnetic theory and power measurement in order to accurately obtain the initial amplitude and phase of each radiation source remains an issue to be studied in the field calibrating phased array antenna systems.

Most of the existing literatures and current methods use the Rotating Element Electric Field Vector (REV) method for phase compensation. However, since the Rotating Element Electric Field Vector method must adjust each phase shifter and measure the variation of power total of all antennas in an antenna array at the same time, the measurement session is agonizingly long and seems unrealistic to phased array systems under a changeable operating environment that require intensive calibrations.

ZHANG LU ET AL: "Amplitude and phase correction of the phased array antenna by REV algorithm", 2017 2 ND INTERNATIONAL CONFERENCE ON IMAGE, VISION AND COMPUTING (ICIVC), IEEE, 2 June 2017 (2017-06-02), pages 913-917, XP033124939, DOI: 10.1109/ICIVC.2017.7984687 [retrieved on 2017-07-18] discloses a method for amplitude and phase correction of a phased array antenna.

**SUMMARY**

The subject matter of the invention is defined by each of independent claims 1 and 8.

In order to overcome the above shortcomings, the present invention provides an antenna array calibration device and an antenna array calibration method.

According to an embodiment of the present invention, an antenna array calibration device, applied to an antenna array comprising a plurality of antennas, the antenna array calibration device comprises: a processor, configured to analyze and calculate whether is a real number solution of a simultaneous equation of amplitudes and phases; and a controller, configured to adjust the antennas from having an initial phase to having a random phase, and adjust the antennas from having an initial amplitude to having a maximum amplitude; wherein the processor calculates a phase difference by subtracting one of the initial phase and the random phase from the other, calculates an amplitude difference by subtracting one of the initial amplitude and the maximum amplitude from the other, and introduces the phase difference, the amplitude difference and a power total of the antenna array into the simultaneous equation of amplitudes and phases; if there is a real number solution for the simultaneous equation of amplitudes and phases, the controller obtains initial amplitudes and initial phases of the antennas to calibrate the phase of the antenna array; and if there is no real number solution for the simultaneous equation of amplitudes and phases, the controller adjusts the antennas to having another random phase different from the random phase, and the processor recalculates the simultaneous equation of amplitudes and phases according to

the other random phase in order to obtain a real number solution.

According to another embodiment of the present invention, an antenna array calibration method, applied to an antenna array, wherein the antenna array is composed of a plurality of antennas, a plurality of phase shifters and a plurality of active components, each of the antennas is coupled to a corresponding phase shifter among the phase shifters and to a corresponding active component among the active components, and the antenna array calibration method comprises: measuring a power total of the antenna array; controlling the active components to adjust the antennas from having an initial amplitude to having a maximum amplitude; controlling the phase shifters to adjust the antennas from having an initial phase to having a random phase; calculating a phase difference by subtracting one of the initial phase and the random phase from the other, calculating an amplitude by subtracting one of the initial amplitude and the maximum amplitude from the other, introducing the phase difference, the amplitude difference and the power total of the antenna array into a simultaneous equation of amplitudes and phases in order to calculate whether there is a real number solution for the simultaneous equation of amplitudes and phases; if there is a real number solution for the simultaneous equation of amplitudes and phases, obtaining initial amplitudes and initial phases of the antennas to calibrate the phase of the antenna array; and if there is no real number solution for the simultaneous equation of amplitudes and phases, controlling the phase shifters to adjust the antennas to having another random phase different from the random phase, and recalculating the simultaneous equation of amplitudes and phases according to the other random phase in order to obtain a real number solution.

In view of the above description, the main purpose of the present invention may be to obtain a real number solution, which is the initial amplitude and initial phase of each antenna, by adjusting the phase difference, amplitude difference of each antenna in any antenna array, and the power total of the antenna array for the antenna array by the simultaneous equation of amplitudes and phases. It may be used to quickly calibrate the antenna array. If it cannot obtain a real number solution by the simultaneous equation of amplitudes and phases, the present invention may merely re-adjust the phase of each antenna in the antenna array until it is a real number solution by the simultaneous equation of amplitudes and phases, and the efficiency of the calibrating antenna may be greatly improved.

## BRIEF DESCRIPTION OF THE DRAWINGS

FIG.1 is a schematic view of an antenna array calibration device according to an embodiment of the present invention.

FIG. 2 is a zoomed-in view of the antenna array calibration device according to an embodiment of the present invention.

FIG. 3 is a flow chart of an antenna array calibration method according to an embodiment of the present invention.

FIG. 4 is a schematic view of the power circle generated by the simultaneous equation of amplitudes and phases according to the present invention.

FIG. 5A is a schematic view of an actual initial phase of a $16 \times 16$ antenna array.

FIG. 5B is a schematic view of a calculated initial phase of the $16 \times 16$ antenna array of FIG. 5A according to another embodiment of the present invention.

FIG. 5C is a schematic view of the phase difference between FIG. 5A and FIG. 5B.

FIG. 5D is a schematic view of the phase distribution of the calculated phase of the $16 \times 16$ antenna array of FIG. 5A according to another embodiment of the present invention.

FIG. 6 is a schematic view of the phase difference between before and after calibration according to another embodiment of the present invention.

## DETAILED DESCRIPTION

The phased array is based on the linear superposition principle, where the radiation electric field of an antenna array system can be formed by superposing multiple electric fields of each antenna. However, due to the initial phase and the initial amplitude of each radio frequency (RF) path not in consistency as well as the coupling effect between antennas, the difference between the initial electric fields at one end of the antennas is driven large. The objective of the present invention uses mathematical methods to calculate the initial electric field of each antenna of the antenna array, and thereby uses a phase adjustable phase shifter and an amplitude adjustable attenuator to compensate for the difference between the initial electric fields.

Because the radiation electric field is a complex number, it has two variables: phase and amplitude. The two variables must be solved using two equations to obtain a simultaneous solution of a simultaneous equation of amplitudes and phases. The phase shifter is used to adjust the phase, which can provide a leading phase or a lagged phase. The attenuator is used to adjust the amplitude, which can generate an amplified amplitude or attenuated amplitude. For example, the attenuator can achieve amplification or attenuation according to different attenuation factors.

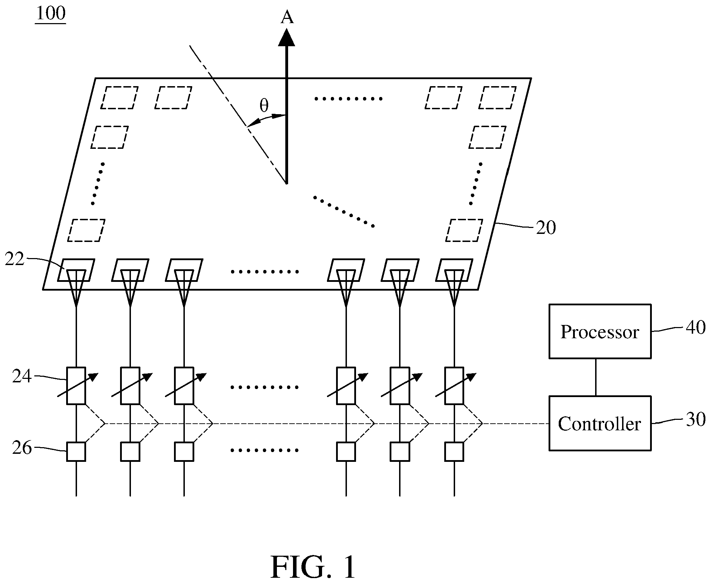

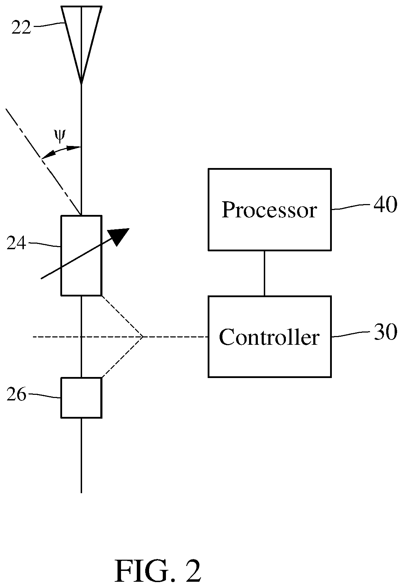

Refer to FIG. 1 and FIG. 2. FIG. 1 is a schematic view of an antenna array calibration device 100 according to an embodiment of the present invention, and FIG. 2 is a zoomed-in view of the antenna array calibration device 100 according to an embodiment of the present invention.

In an embodiment, as illustrated in FIG. 1, the antenna array calibration device 100 is applied to an antenna array 20. The antenna array 20 comprises a plurality of antennas 22, and the antenna array calibration device 100 comprises a controller 30 and a processor 40.

In some embodiments, the antennas 22 can be one-dimensionally or two-dimensionally arranged in the antenna array 20, but the present invention does not limit the dimension of the antennas 22 of the antenna array 20 to be arranged in particular ways. For example, the technical means of the present invention can also be applied to a three-dimensional structure. In some embodiments, the antenna array 20 of the present disclosure can be implemented as a single set or multiple sets in a communication device. The communication device can be a mobile communication device, a mobile computing device, a computer device, a telecommunication device, a base station device, a wireless bridge device, a network equipment, a computer or network peripherals, etc. In some embodiments, the antenna array calibration device 100 can comprise one or more antenna arrays 20, and the number of antennas 22 assigned to an antenna array 20 depends on actual design requirements. For example, the antenna array 20 shown in FIG. 1 can be composed of M×N antennas 22, wherein both M and N are positive integers. In some embodiments, the antenna array 20 can be composed of 256 (16×16) antennas 22.

The controller 30 is configured to adjust each antenna 22 from having an initial phase to having a random phase, and adjust the antennas 22 from having an initial amplitude to having a maximum amplitude.

In an embodiment, the antenna array calibration device 100 may comprise a plurality of phase shifters 24 and a plurality of active elements 26. In some embodiments, each antenna 22 can be coupled to a corresponding one of the phase shifters 24 and a corresponding one of the active elements 26. For example, the embodiment of FIG. 1 illustrates that each phase shifter 24 is coupled between a corresponding antenna 22 and active element 26, while other embodiments may instead arrange each active element 26 to be coupled between a corresponding antenna 22 and phase shifter 24. In some embodiments, the active elements 26 can be implemented with at least one of digital attenuators, analog attenuators, operational amplifiers and variable gain amplifiers (VGA). In some embodiments, in addition to the phase shifters 24 and the active elements 26, each antenna 22 can be coupled to one or more elements, such as a driver, a detector, a splitter (beam splitter), a temperature controller, a filter, a converter, a rectifier, a digital-to-analog converter, an another phase shifter, an another active component, a chip, a circuit, or a feedback circuit, etc. The above chip or the above circuit may be, for example, an electronic circuit, an integrated circuit, a microchip, and an active/passive semiconductor component, etc.

In an embodiment, each antenna 22 can be used to transmit or receive signals, such as radio frequency (RF) signals. In some embodiments, each antenna 22 can handle a single signal beam or multiple signal beams. In some embodiments, the antenna array 20 can control a phase shifter 24 of each antenna 22 through the controller 30 in order to adjust the phase of each antenna 22. For example, the controller 30 controls the antennas 22 to adjust from having the initial phase to having a random phase. In some embodiments, the phase variation (i.e. the phase difference) between the random phase and the initial phase can be in any angle, such as 1 degree, 10 degrees, 15 degrees, 45 degrees, or 90 degrees.

In an embodiment, the antenna array 20 can control an active element 26 of each antenna 22 through the controller 30 in order to adjust the amplitude of each antenna 22. For example, the controller 30 adjusts the antennas 22 to from having the initial amplitude to having a maximum amplitude.

The processor 40 is configured to analyze and calculate whether there is a real number solution for a simultaneous equation of amplitudes and phases. In some embodiments, the processor 40 may be a device capable of executing coded arithmetic, logic, and/or I/O operating commands. In some embodiments, the processor 40 can comprise an arithmetic logic unit (ALU), a control unit, and/or a register, wherein the above register can be any type of fixed or removable random access memory (RAM), read-only memory (ROM), flash memory, hard disk drive (HDD), solid state drive (SSD), similar elements or a combination of the above elements. In some embodiments, the processor 40 and the controller 30 can be integrated in a same chip or container. In some embodiments, the antenna array calibration device 100 may comprise one or more processors 40. In some embodiments, the processor 40 is a single-core processor capable of executing one command each time (or executing a single command pipeline), or a multi-core processor capable of executing multiple commands at the same time. In some embodiments, the processor 40 may be one or more integrated circuits. In some embodiments, the processor 40 may be a central processing unit (CPU), other programmable general-purpose or special-purpose microprocessors, a digital signal processor (DSP), a programmable controller, an application specific integrated circuit (ASIC), other similar components or a combination of any of the above components, but the disclosure is not limited to the embodiments. In some embodiments, the processor 40 may comprise an interconnection or transmission function, such as a wireless network function or a local area network function.

In some embodiments, the above simultaneous equation of amplitudes and phases can be expressed by the following Equation 1 and Equation 2:

$$\left(X_n + \frac{\sqrt{P_\alpha}}{1-\alpha}\right)^2 + Y_n{}^2 = \left(\frac{\sqrt{P_0}}{1-\alpha}\right)^2 \qquad \ldots \text{Equation 1}$$

$$\left(X_n + \frac{\sqrt{P_\alpha}(\cos\psi - \alpha)}{\alpha^2 - 2\alpha\cos\psi + 1}\right)^2 + \left(y_n + \frac{\sqrt{P_\alpha}\sin\psi}{\alpha^2 - 2\alpha\cos\psi + 1}\right)^2 = \left(\frac{\sqrt{P_\Phi}}{\alpha^2 - 2\alpha\cos\psi + 1}\right)^2 \ldots \text{Equation 2}$$

wherein the parameter $P_\alpha$ in Equation 1 and Equation 2 denotes the power total (in linear coordinates) of the nth antenna 22 of the antenna array 20 with the amplitude being adjusted by $\alpha$ (e.g. amplified or attenuated by $\alpha$), the parameter $P_0$ denotes the power total of the antenna array 20 under an initial state, and the parameter $P_\Phi$ denotes the power total of the nth antenna of the antenna array 20 with the phase being adjusted by $\psi$.

The variables $X_n$ and $Y_n$ in Equation 1 and Equation 2 are unknown variables that need to be calculated, and can be expressed by the following Equation 3 and Equation 4:

$$X_n = |E_n| \cos\psi_n \qquad \ldots \text{Equation 3}$$

$$Y_n = |E_n| \sin\psi_n \qquad \ldots \text{Equation 4}$$

wherein the parameter $E_n$ and $\phi_n$ in Equation 3 and Equation 4 are the initial amplitude and the initial phase of the nth antenna 22 in the antenna array 20, respectively.

In an embodiment, as illustrated in FIG. 2, the processor 40 may calculate a phase difference according to the adjustment from the initial phase to the random phase (e.g. the phase shifting angle $\psi$ shown in FIG. 2). For example, the phase difference may be calculated by subtracting one of the initial phase and the random phase from the other. In addition, the processor 40 may calculate the above-mentioned amplitude difference according to the adjustment from the initial amplitude to the maximum amplitude. For example, the amplitude difference may be calculated by subtracting one of the initial amplitude and the maximum amplitude from the other. The processor 40 introduces the above-mentioned phase difference, the above-mentioned amplitude difference and the power total of the antenna array 20 into the above-mentioned simultaneous equation of amplitudes and phases, to obtain a real number solution.

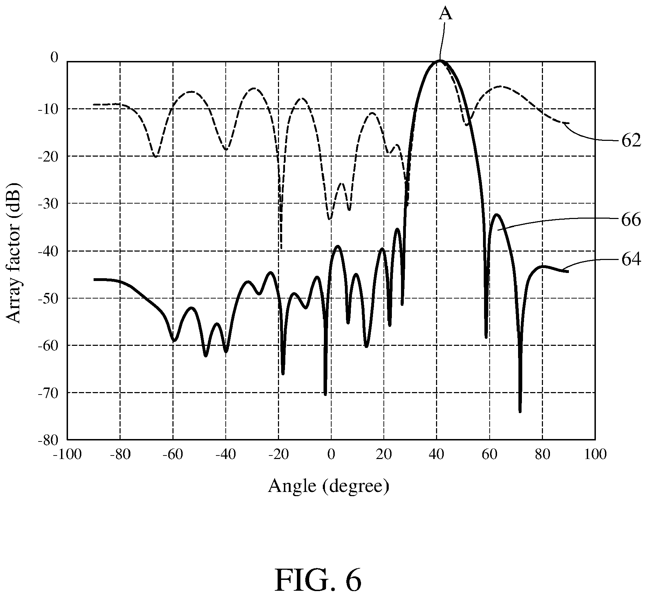

If there is a real number solution in the above-mentioned simultaneous equation of amplitudes and phases, meaning that the initial amplitude $E_n$ and the initial phase $\psi_n$ of each antenna 22 can be generated. The controller 30 can calibrate the phase of the antenna array 20 according to the calculation of the above-mentioned initial amplitude and the above-mentioned initial phase of each antenna 22, and perform phase compensation to make the main beam A of the antenna array 20 (see FIG. 1 and FIG. 6) reach a predetermined target angle, such as the calibrated angle $\theta$ shown in FIG. 1.

If there is no real number solution in the above-mentioned simultaneous equation of amplitudes and phases, the controller 30 will again control the antennas 22 to adjust to having another random phase that is different from the above-mentioned random phase, and the processor 40 recalculates the above simultaneous equation of amplitudes and phases to obtain a real number solution according to the above-mentioned another random phase. In some embodiments, for example, the phase difference between two consecutive random phases can be fixed to 1 degree, 10 degrees, 15 degrees, 45 degrees, or 90 degrees. In some embodiments, the present invention requires can obtain the real number solution by merely using the controller 30 to adjust the phase variation for one time and adjust the amplitude variation for one time to obtain the initial phase and the initial amplitude of an antenna 22. For example, to solve the above simultaneous equation of amplitudes and phases using the antenna array 20 composed of 256 (16×16) antennas 22 implemented in the present invention, it requires merely 512 (256×2) phase modulations and power measurements,. That is, it takes only 512 phase modulations to complete the phase calibration of the antenna array 20.

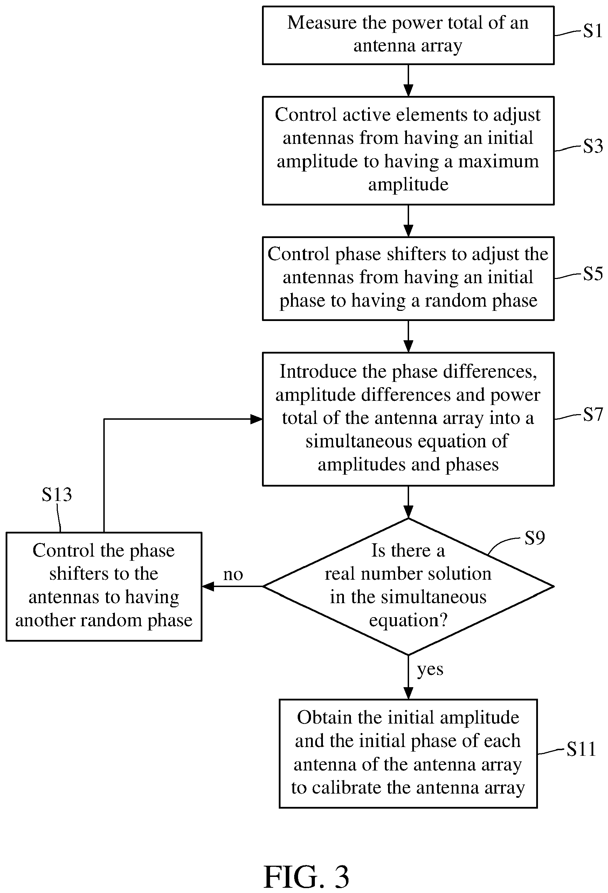

Refer to FIG. 3, FIG. 3 is a flow chart of an antenna array calibration method according to an embodiment of the present invention.

In an embodiment, as illustrated in Step S1 of FIG. 3, a processor 40 measures the power total of an antenna array 20.

In Step S3, a controller 30 controls the active elements 26 to adjust the antennas 22 from having an initial amplitude to having a maximum amplitude.

In Step S5, the controller 30 controls the phase shifters 24 to adjust the antennas 22 from having an initial phase to having a random phase.

In Step S7, the processor 40 calculates a phase difference by subtracting one of the above-mentioned initial phase and the above-mentioned random phase from the other, and the processor 40 calculates an amplitude difference by subtracting one of the above-mentioned initial amplitude and the above-mentioned maximum amplitude from the other. The processor 40 introduces the above-mentioned phase difference, the above-mentioned amplitude difference and the power total of the antenna array 20 into the above-mentioned simultaneous equation of amplitudes and phases. In Step S9, the processor 40 determines whether there is a real number solution in the above-mentioned simultaneous equation of amplitudes and phases.

In Step S11, if there is a real number solution in the above-mentioned simultaneous equation of amplitudes and phases, the processor 40 will obtain the above-mentioned initial amplitude and initial phase of the antenna array 20, and the controller 30 will perform phase compensation to calibrate the antenna array 20 according to the above-mentioned initial amplitude and the above-mentioned initial phase.

In Step S13, if there is no real number solution in the above-mentioned simultaneous equation of amplitudes and phases, the controller 30 will again control the phase shifters 24 to adjust the antennas 22 of the antenna array 20 from having the random phase to having another random phase, and the processor 40 will recalculate the above-mentioned simultaneous equation of amplitudes and phases until a real number solution is generated.

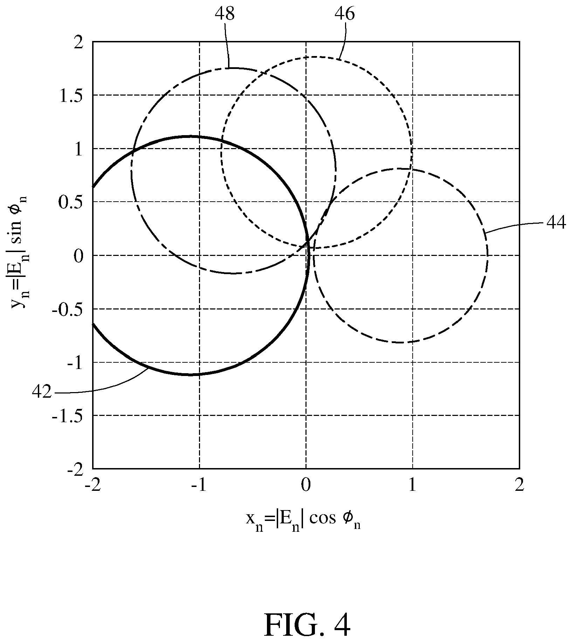

Refer to FIG. 4, FIG. 4 is a schematic view of the power circle generated by the simultaneous equation of amplitudes and phases according to the present invention.

In an embodiment, as illustrated in FIG. 4, because the above-mentioned initial phase and the above-mentioned initial amplitude of the antennas 22 cannot be estimated (a random distribution), in the linear coordinate system of the variable $X_n$ as the X-axis and variable $Y_n$ as the Y-axis according to the above-mentioned simultaneous equation of amplitudes and phases, a first power circle 42 can be obtained after an amplitude adjustment (amplification or attenuation) $\alpha$ by the Equation 1, and a second power circle 44, a third power circle 46 and a fourth power circle 48 can be obtained after phase shifting angle $\psi_1$, $\psi_2$, and $\psi_3$ respectively by the Equation 2.

When angles are adjusted to different angles (e.g. $\psi_1$, $\psi_2$, $\psi_3$) and the power total obtained by modulating the phase is less than the power total obtained by modulating the attenuation, improper phase shifting angles (e.g. $\psi_1$) will result in real number solution not existed, e.g., the first power circle 42 and the second power circle 44 have no intersection point (no real number solution). Appropriate phase shifting angles (e.g. $\psi_2$, $\psi_3$), however, will result in a real number solution existed, e.g., the first power circle 42 intersects with and the third power circle 46 and the fourth power circle 48 and therefore have two intersection points, in which intersection points indicate that there is a real number solution. Therefore, the present invention provides to change the phase shift angle $\psi$ of the antennas 22 according to any random phase (see FIG. 2), which is to change the center point of the power circle converted by Equation 2, in order to obtain a real number solution. In some embodiments, the present invention may continuously generate random phases to generate different power circles until a real number solution is generated.

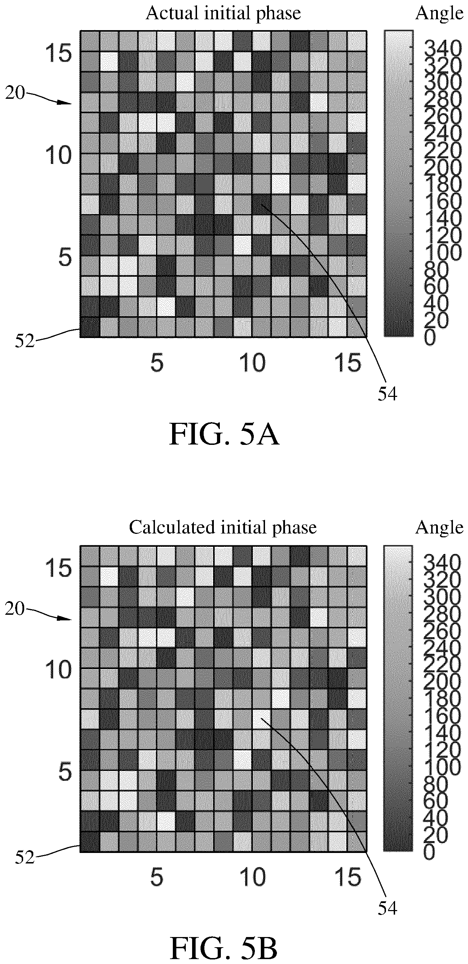

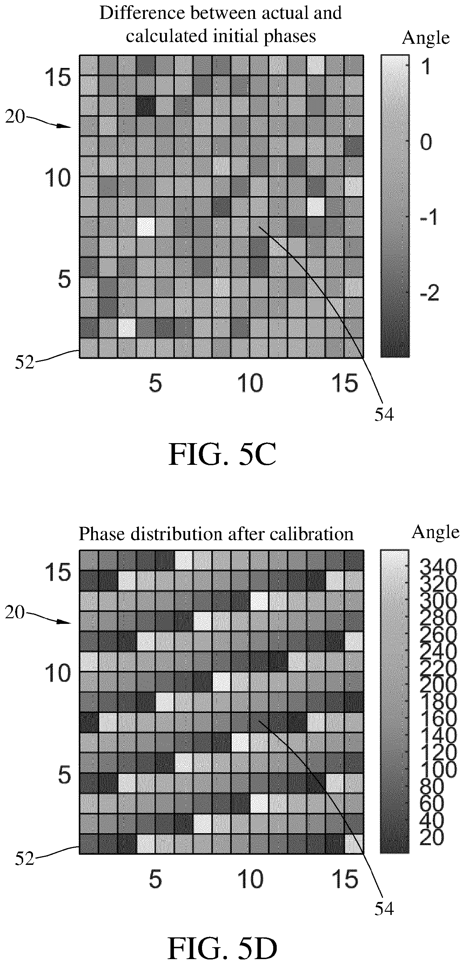

Refer to FIG. 5A, FIG. 5B, FIG. 5C and FIG. 5D. FIG. 5A to FIG. 5D are the phase values of each antenna of a 16 × 16 antenna array. FIG. 5A is a schematic view of an actual initial phase of a 16 × 16 antenna array. FIG. 5B is a schematic view of a calculated initial phase of the 16 × 16 antenna array of FIG. 5A according to another embodiment of the present invention. FIG. 5C is a schematic view of the phase difference between FIG. 5A and FIG. 5B. FIG. 5D is a schematic view of the phase distribution of the calculated phase of the 16 × 16 antenna array of FIG. 5A according to another embodiment of the present invention.

In an embodiment, as illustrated in FIG. 5A, there is an antenna array 20 as an example. The above-mentioned antenna array 20 is composed of 256 (16 × 16) antennas 22. Because each antenna 22 has a different initial phase, it is expressed in different gray scales, for example, both a first antenna 52 and a second antenna 54 have a random initial phase of 0 degrees as the same gray scale.

Regarding the Rotating Element Electric Field Vector (REV) method, since the power total of the antenna array 20 and the cosine variation of the phase of the phase shifters 24 of the antennas 22 is in consistency, it can be used to adjust the phase of the phase shifter 24 of each antenna 22 sequentially, in order to obtain the cosine curve of the power total difference, and calculate the initial phase and initial amplitude of each antenna 22 as a basis for calibration. Take a 5-bit digital phase shifter as an example, it requires changing the phase of each antenna 32 times and measuring the power total of the antenna array 32 times by using the Rotating Element Electric Field Vector (REV) method. As to the antenna array 20 composed of 256 (16×16) antennas 22, it requires performing phase modulation and power measurements 8192 (256×32) times.

In an embodiment, as illustrated in FIG. 5B, according to the present invention implemented in an antenna array 20 composed of 256 (16 × 16) antennas 22, it only requires to calculate at least 512 (256×2) times about phase modulations and power measurements by using the above-mentioned simultaneous equation of amplitudes and phases. This fast calibration not only greatly reduces the time-consuming of calibration of the antenna array 20, but improves its performance. For example, the initial phase calculated by the first antenna 52 according to another embodiment of the present invention is close to 0 degrees, and the initial phase calculated by the second antenna 54 according to another embodiment of the present invention is close to 359 degrees.

In an embodiment, as illustrated in FIG. 5C, the actual initial phase shown in FIG. 5A and the initial phase calculated according to another embodiment of the present invention shown in FIG. 5B have a phase error. For example, the phase error obtained by the first antenna 52 is close to 0 degrees, and the phase error obtained by the second antenna 54 is close to -1 degree.

In an embodiment, as illustrated in FIG. 5D, according to the result of the simultaneous equation of amplitudes and phases calculated by the processor 40, the controller 30 adjusts the phase shifter 24 of each antenna 22 for calibration. For example, with the aid of the phase distribution of the antenna array 20 after calibration in FIG. 5D, the main beam A (see FIG. 1 and FIG. 6) of the antenna array 20 can reach a predetermined target angle (such as 41.05 degrees), wherein the phase of the first antenna 52 after calibration according to another embodiment of the present invention is close to 60 degrees, and the phase of the second antenna 54 after calibration according to another embodiment of the present invention is close to 60 degrees.

Refer to FIG. 6, FIG. 6 is a schematic view of the phase difference between before and after calibration according to another embodiment of the present invention.

In an embodiment, as illustrated in FIG. 6, the X-axis is the beam angle of the antenna array 20, and the Y-axis is the size of the array factor in dB. In an embodiment, the beam before calibration 62 of the antenna array 20 composed of 256 (16×16) antennas 22 which shown in FIG. 5A to FIG. 5D is shown by the dotted line in FIG. 6. In order to make the main beam A reach a predetermined target angle (such as 41.05 degrees), the controller 30 adjusts the angle of the phase shifter 24 of each antenna 22, and adjusts the attenuator 26 of each antenna 22 at the same time according to the condition that is the side lobe level -30 dB. The beam after calibration 64 of the antenna array 20 is shown by the solid line in FIG. 6, and the corrected beam 64 can have a maximum side lobe 66, which is a specification below -30 dB. The above-mentioned side lobe setting to -30 dB is for illustrative purposes only, rather than limiting the scope of the present invention.

The present invention can adjust the phase difference, amplitude difference of each antenna in any antenna array, and the power total of the antenna array for the antenna array to obtain a real number solution by the simultaneous equation of amplitudes and phases, which is the initial amplitude and initial phase of each antenna. It can be used to quickly calibrate the antenna array. If it cannot obtain a real number solution by the simultaneous equation of amplitudes and phases, the present invention can re-adjust the phase of each antenna in the antenna array again to another random angle until it is a real number solution by the simultaneous equation of amplitudes and phases. As a result, the efficiency of the calibrating antenna can be greatly improved. In other words, the present invention can properly calibrate the antenna array with lower operation complexity.

### Claims

1. An antenna array calibration device (100), applied to an antenna array (20) comprising a plurality of antennas (22), wherein the antenna array calibration device (100) comprises:

   a processor (40), configured to analyze and calculate whether is a real number solution of a simultaneous equation of amplitudes and phases; and
   a controller (30), configured to adjust the antennas (22) from having an initial phase to having a random phase, and adjust the antennas (22) from having an initial amplitude to having a maximum amplitude;
   wherein the processor (40) is configured to calculate a phase difference by subtracting one of the initial phase and the random phase from the other, calculate an amplitude difference by subtracting one of the initial amplitude and the maximum amplitude from the other, and introduce the phase difference, the amplitude difference and a power total of the antenna array (20) into the simultaneous equation of amplitudes and phases;
   if there is a real number solution for the simultaneous equation of amplitudes and phases, the controller (30) is configured to obtain initial amplitudes and initial phases of the antennas (22) to calibrate the phase of the antenna array (20); and
   if there is no real number solution for the simultaneous equation of amplitudes and phases, the controller (30) is configured to adjust the antennas (22) to having another random phase different from the random phase, and the processor (40) is configured to recalculate the simultaneous equation of amplitudes and phases according to the another random phase in order to obtain a real number solution.

2. The antenna array calibration device (100) according to claim 1, further comprising a plurality of phase shifters (24) and a plurality of active components (26), wherein each of the antennas (22) is coupled to a corresponding phase shifter among the phase shifters (24) and to a corresponding active component among the active components (26).

3. The antenna array calibration device (100) according to claim 2, wherein the controller (30) is configured to control the phase shifters (24) to adjust the antennas (22) from having the initial phase to having the random phase.

4. The antenna array calibration device (100) according to claim 2, wherein the controller (30) is configured to control the phase shifters (24) to adjust the antennas to having the another random phase different from the random phase.

5. The antenna array calibration device (100) according to claim 2, wherein the controller (30) is configured to control the active components (26) to adjust the antennas (22) from having the initial amplitude to having the maximum amplitude.

6. The antenna array calibration device (100) according to claim 2, wherein the active components (26) further comprises: at least one of a digital attenuator, an analog attenuator, an amplifier and a variable gain amplifier "VGA".

7. The antenna array calibration device (100) according to claim 2, wherein the antennas (22) are one-dimensionally or two-dimensionally arranged in the antenna array (20).

8. An antenna array calibration method, applied to an antenna array (20), wherein the antenna array (20) is composed of a plurality of antennas (22), a plurality of phase shifters (24) and a plurality of active components (26), each of the antennas (22) is coupled to a corresponding phase shifter among the phase shifters (24) and to a corresponding active component among the active components (26), and wherein that the antenna array calibration method comprises:

measuring a power total of the antenna array (20);
controlling the active components (26) to adjust the antennas (22) from having an initial amplitude to having a maximum amplitude;
controlling the phase shifters (24) to adjust the antennas (22) from having an initial phase to having a random phase;
calculating a phase difference by subtracting one of the initial phase and the random phase from the other, calculating an amplitude by subtracting one of the initial amplitude and the maximum amplitude from the other, introducing the phase difference, an amplitude difference and the power total of the antenna array (20) into a simultaneous equation of amplitudes and phases in order to calculate whether there is a real number solution for the simultaneous equation of amplitudes and phases;
if there is a real number solution for the simultaneous equation of amplitudes and phases, obtaining initial amplitudes and initial phases of the antennas (22) to calibrate the phase of the antenna array (20); and
if there is no real number solution for the simultaneous equation of amplitudes and phases, controlling the phase shifters (24) to adjust the antennas (22) to having another random phase different from the random phase, and recalculating the simultaneous equation of amplitudes and phases according to the another random phase in order to obtain a real number solution.

9. The antenna array calibration method according to claim 8, wherein the active components (26) further comprises: at least one of a digital attenuator, an analog attenuator, an amplifier and a variable gain amplifier "VGA".

10. The antenna array calibration method according to claim 8, wherein the antennas (22) are one-dimensionally or two-dimensionally arranged in the antenna array (20).

**Patentansprüche**

1. Antennenarray-Kalibriervorrichtung (100), angewandt auf ein Antennenarray (20) mit mehreren Antennen (22), wobei die Antennenarray-Kalibriervorrichtung (100) aufweist:

einen Prozessor (40), der dazu ausgebildet ist, zu analysieren und zu berechnen, ob eine reelle Zahlenlösung einer simultanen Gleichung von Amplituden und Phasen existiert; und
einen Controller (30), der dazu ausgebildet ist, die Antennen (22) von einer Anfangsphase auf eine zufällige Phase einzustellen, und die Antennen (22) von einer Anfangsamplitude auf eine maximale Amplitude einzustellen;
wobei der Prozessor (40) dazu ausgebildet ist, eine Phasendifferenz durch Subtrahieren der Anfangsphase oder der zufälligen Phase von der anderen Phase zu berechnen, eine Amplitudendifferenz durch Subtrahieren der Anfangsamplitude oder der maximalen Amplitude von der anderen Amplitude zu berechnen, und die Phasendifferenz, die Amplitudendifferenz und eine Gesamtleistung des Antennenarrays (20) in die gleichzeitige Gleichung von Amplituden und Phasen einzusetzen;
der Controller (30) dazu ausgebildet ist, wenn eine reelle Zahlenlösung für die gleichzeitige Gleichung von Amplituden und Phasen existiert, Anfangsamplituden und Anfangsphasen der Antennen (22) zu erfassen, um die Phase des Antennenarrays (20) zu kalibrieren; und
der Controller (30) dazu ausgebildet ist, wenn keine reelle Zahlenlösung für die gleichzeitige Gleichung von Amplituden und Phasen existiert, die Antennen (22) auf eine andere zufällige Phase einzustellen, die von der zufälligen Phase verschieden ist, und der Prozessor (40) dazu ausgebildet ist, die simultane Gleichung von Amplituden und Phasen gemäß der anderen zufälligen Phase erneut zu berechnen, um eine reelle Zahlenlösung zu erhalten.

2. Antennenarray-Kalibrierungsvorrichtung (100) nach Anspruch 1, ferner mit mehreren Phasenschiebern (24) und mehreren aktiven Komponenten (26), wobei jede der Antennen (22) mit einem entsprechenden Phasenschieber unter den Phasenschiebern (24) und mit einer entsprechenden aktiven Komponente unter den aktiven Komponenten (26) gekoppelt ist.

3. Antennenarray-Kalibriervorrichtung (100) nach Anspruch 2, bei welcher der Controller (30) dazu ausgebildet ist, die Phasenschieber (24) zum Einstellen der Antennen (22) von der Anfangsphase auf die zufällige Phase zu steuern.

4. Antennenarray-Kalibriervorrichtung (100) nach Anspruch 2, bei welcher der Controller (30) dazu ausgebildet ist, die Phasenschieber (24) zum Einstellen der Antennen auf eine von der zufälligen Phase verschiedene, andere zufällige Phase zu steuern.

5. Antennenarray-Kalibriervorrichtung (100) nach Anspruch 2, bei welcher der Controller (30) dazu ausgebildet ist, die aktiven Komponenten (26) zum Einstellen der Antennen (22) von der Anfangsamplitude auf die maximale Amplitude zu steuern.

6. Antennenarray-Kalibriervorrichtung (100) nach Anspruch 2, bei welcher die aktiven Komponenten (26) ferner einen digitalen Dämpfer und/oder einen analogen Dämpfer und/oder einen Verstärker und/oder einen Verstärker mit variabler Verstärkung "VGA" aufweisen.

7. Antennenarray-Kalibriervorrichtung (100) nach Anspruch 2, bei welcher die Antennen (22) eindimensional oder zweidimensional in dem Antennenarray (20) angeordnet sind.

8. Antennenarray-Kalibrierverfahren, angewandt auf ein Antennenarray (20), wobei das Antennenarray (20) aus mehreren Antennen (22), mehreren Phasenschiebern (24) und mehreren aktiven Komponenten (26) besteht, wobei jede der Antennen (22) mit einem entsprechenden Phasenschieber unter den Phasenschiebern (24) und einer entsprechenden aktiven Komponente (26) unter den aktiven Komponenten (26) gekoppelt ist; und
wobei das Antennenarray-Kalibrierverfahren die folgenden Schritte aufweist:

Messen einer Gesamtleistung des Antennenarrays (20);
Steuern der aktiven Komponenten (26) zum Einstellen der Antennen (22) von einer Anfangsamplitude auf eine maximale Amplitude;
Steuern der Phasenschieber (24) zum Einstellen der Antennen (22) von einer Anfangsphase auf eine zufällige Phase;
Berechnen einer Phasendifferenz durch Subtrahieren der Anfangsphase oder der zufälligen Phase von der anderen Phase zu berechnen, Berechnen einer Amplitudendifferenz durch Subtrahieren der Anfangsamplitude oder der maximalen Amplitude von der anderen Amplitude, und Einsetzen der Phasendifferenz, der Amplitudendifferenz und einer Gesamtleistung des Antennenarrays (20) in die gleichzeitige Gleichung von Amplituden und Phasen, um zu berechnen, ob eine reelle Zahlenlösung der simultanen Gleichung von Amplituden und Phasen existiert;
wenn eine reelle Zahlenlösung für die gleichzeitige Gleichung von Amplituden und Phasen existiert, Erfassen der Anfangsamplituden und Anfangsphasen der Antennen (22), um die Phase des Antennenarrays (20) zu kalibrieren; und
wenn keine reelle Zahlenlösung für die gleichzeitige Gleichung von Amplituden und Phasen existiert, Steuern der Phasenschieber (24) zum Einstellen der Antennen (22) auf eine andere zufällige Phase, die von der zufälligen Phase verschieden ist, und erneutes Berechnen der simultanen Gleichung von Amplituden und Phasen gemäß der anderen zufälligen Phase, um eine reelle Zahlenlösung zu erhalten.

9. Antennenarray-Kalibrierverfahren nach Anspruch 8, bei welchem die aktiven Komponenten (26) ferner einen digitalen Dämpfer und/oder einen analogen Dämpfer und/oder einen Verstärker und/oder einen Verstärker mit variabler Verstärkung "VGA" aufweisen.

10. Antennenarray-Kalibrierverfahren nach Anspruch 8, bei welchem die Antennen (22) eindimensional oder zweidimensional in dem Antennenarray (20) angeordnet sind.

**Revendications**

1. Dispositif d'étalonnage de réseau d'antennes (100), appliqué à un réseau d'antennes (20) comprenant une pluralité d'antennes (22),
dans lequel le dispositif d'étalonnage de réseau d'antennes (100) comprend :

un processeur (40), configuré pour analyser et calculer s'il existe une solution en nombre réel d'une équation simultanée d'amplitudes et de phases ; et
un dispositif de commande (30), configuré pour ajuster les antennes (22) depuis avoir une phase initiale à avoir une phase aléatoire, et pour ajuster les antennes (22) depuis avoir une amplitude initiale à avoir une amplitude maximale ;
dans lequel le processeur (40) est configuré pour calculer une différence de phases en soustrayant l'une de la phase initiale et de la phase aléatoire à l'autre, calculer une différence d'amplitudes en soustrayant l'une de l'amplitude initiale et de l'amplitude maximale à l'autre, et introduire la différence de phase, la différence d'amplitude et un total de puissance du réseau d'antennes (20) dans l'équation simultanée d'amplitudes et de phases ;
s'il existe une solution en nombre réel pour l'équation simultanée d'amplitudes et de phases, le dispositif de commande (30) est configuré pour obtenir des amplitudes initiales et des phases initiales des antennes (22) pour étalonner la phase du réseau d'antennes (20) ; et
s'il n'existe pas de solution en nombre réel pour l'équation simultanée d'amplitudes et de phases, le dispositif de commande (30) est configuré pour ajuster les antennes (22) pour qu'elles aient une autre phase aléatoire différente de la phase aléatoire, et le processeur (40) est configuré pour recalculer l'équation simultanée d'amplitudes et de phases selon l'autre phase aléatoire afin d'obtenir une solution en nombre réel.

2. Dispositif d'étalonnage de réseau d'antennes (100) selon la revendication 1, comprenant en outre une pluralité de déphaseurs (24) et une pluralité de composants actifs (26), dans lequel chacune des antennes (22) est couplée à un déphaseur correspondant parmi les déphaseurs (24) et à un composant actif correspondant parmi les composants actifs (26).

3. Dispositif d'étalonnage de réseau d'antennes (100) selon la revendication 2, dans lequel le dispositif de commande (30) est configuré pour commander les déphaseurs (24) afin d'ajuster les antennes (22) depuis avoir la phase initiale à avoir la phase aléatoire.

4. Dispositif d'étalonnage de réseau d'antennes (100) selon la revendication 2, dans lequel le dispositif de commande (30) est configuré pour commander les déphaseurs (24) afin d'ajuster les antennes pour qu'elles aient l'autre phase aléatoire différente de la phase aléatoire.

5. Dispositif d'étalonnage de réseau d'antennes (100) selon la revendication 2, dans lequel le dispositif de commande (30) est configuré pour commander les composants actifs (26) afin d'ajuster les antennes (22) depuis avoir l'amplitude initiale à avoir l'amplitude maximale.

6. Dispositif d'étalonnage de réseau d'antennes (100) selon la revendication 2, dans lequel les composants actifs (26) comprennent en outre : au moins un élément parmi un atténuateur numérique, un atténuateur analogique, un amplificateur et un amplificateur à gain variable « VGA ».

7. Dispositif d'étalonnage de réseau d'antennes (100) selon la revendication 2, dans lequel les antennes (22) sont agencées de manière unidimensionnelle ou bidimensionnelle dans le réseau d'antennes (20).

8. Procédé d'étalonnage de réseau d'antennes, appliqué à un réseau d'antennes (20), dans lequel le réseau d'antennes (20) est composé d'une pluralité d'antennes (22), d'une pluralité de déphaseurs (24) et d'une pluralité de composants actifs (26), chacune des antennes (22) est couplée à un déphaseur correspondant parmi les déphaseurs (24) et à un composant actif correspondant parmi les composants actifs (26), et

dans lequel le procédé d'étalonnage de réseau d'antennes comprend les étapes consistant à
mesurer une puissance totale du réseau d'antennes (20) ;
commander les composants actifs (26) pour ajuster les antennes (22) depuis avoir une amplitude initiale à avoir une amplitude maximale ;
commander les déphaseurs (24) pour ajuster les antennes (22) depuis avoir une phase initiale à avoir une phase aléatoire ;
calculer une différence de phase en soustrayant l'une de la phase initiale et de la phase aléatoire à l'autre, calculer une amplitude en soustrayant l'une de l'amplitude initiale et de l'amplitude maximale à l'autre, introduire la différence de phase, une différence d'amplitude et la puissance totale du réseau d'antennes (20) dans une équation simultanée d'amplitudes et de phases afin de calculer s'il existe une solution en nombre réel pour l'équation simultanée d'amplitudes et de phases ;
s'il existe une solution en nombre réel pour l'équation simultanée d'amplitudes et de phases, obtenir des amplitudes initiales et des phases initiales des antennes (22) pour étalonner la phase du réseau d'antenne (20) ; et
s'il n'existe pas de solution en nombre réel pour l'équation simultanée d'amplitudes et de phases, commander les déphaseurs (24) pour ajuster les antennes (22) pour qu'elles aient une autre phase aléatoire différente de la phase aléatoire, et recalculer l'équation simultanée d'amplitudes et de phases selon l'autre phase aléatoire afin d'obtenir une solution en nombre réel.

9. Procédé d'étalonnage de réseau d'antennes selon la revendication 8, dans lequel les composants actifs (26) comprennent en outre : au moins l'un d'un atténuateur numérique, d'un atténuateur analogique, d'un amplificateur et d'un amplificateur à gain variable « VGA ».

10. Procédé d'étalonnage de réseau d'antennes selon la revendication 8, dans lequel les antennes (22) sont agencées de manière unidimensionnelle ou bidimensionnelle dans le réseau d'antennes (20).

FIG. 1

EP 4 181 319 B1

FIG. 2

```
┌─────────────────────────────┐
│   Measure the power total of an │ ─S1
│          antenna array          │
└─────────────────────────────┘
               │
               ▼
┌─────────────────────────────┐
│ Control active elements to adjust │
│  antennas from having an initial  │ ─S3
│  amplitude to having a maximum    │
│           amplitude               │
└─────────────────────────────┘
               │
               ▼
┌─────────────────────────────┐
│ Control phase shifters to adjust the │
│   antennas from having an initial    │ ─S5
│   phase to having a random phase     │
└─────────────────────────────┘
               │
               ▼
┌─────────────────────────────┐
│   Introduce the phase differences,  │
│  amplitude differences and power    │
│ total of the antenna array into a   │ ─S7
│     simultaneous equation of        │
│       amplitudes and phases         │
└─────────────────────────────┘
               │
               ▼
```

S13

```
┌──────────────────┐           ◇ ─S9
│  Control the phase │           ╱ Is there a ╲
│  shifters to the   │◄── no ──  ╱ real number solution ╲
│ antennas to having │           ╲ in the simultaneous  ╱
│ another random phase│          ╲   equation?    ╱
└──────────────────┘              ◇
                                   │
                                  yes
                                   │
                                   ▼
                    ┌─────────────────────────────┐
                    │   Obtain the initial amplitude  │
                    │  and the initial phase of each  │ ─S11
                    │  antenna of the antenna array   │
                    │  to calibrate the antenna array │
                    └─────────────────────────────┘
```

# FIG. 3

FIG. 4

FIG. 5A

FIG. 5B

Difference between actual and
calculated initial phases

FIG. 5C

Phase distribution after calibration

FIG. 5D

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Amplitude and phase correction of the phased array antenna by REV algorithm. **ZHANG LU et al.** 2017 2 ND INTERNATIONAL CONFERENCE ON IMAGE, VISION AND COMPUTING (ICIVC). IEEE, 02 June 2017, 913-917